# EUROPÄISCHE PATENTANMELDUNG

(11) **EP 0 994 359 A2**
(43) Veröffentlichungstag der Anmeldung: **19.04.2000**
(21) Anmeldenummer: 99120261.5
(22) Anmeldetag: 11.10.1999
(51) Int. Cl.: G01R 31/28, G01R 1/073

(54) **Testadapter**

(30) Priorität: 13.10.1998 DE 19847146
(71) Anmelder: TEST PLUS ELECTRONIC GMBH, D-80337 München (DE)
(72) Erfinder: Ott, Rainer, Dipl.-Ing., 80997 München (DE)
(74) Vertreter: Körber, Wolfhart, Dr. rer.nat.

(57) **Zusammenfassung**

Die vorliegende Erfindung betrifft einen Testadapter zum Testen einer Leiterplatine (6). Der erfindungsgemäße Testadapter umfaßt eine Nadelträgerplatte (1), an der Testnadeln (3) zum Kontakt der Kolben (3a) der Testnadeln (3) mit Testpunkten (7) der Leiterplatine (6) befestigt sind, eine Leiterplatinenträgerplatte (4), an der die Leiterplatine (6) koppelbar ist, die zwischen der Leiterplatine (6) und der Nadelträgerplatte (1) angeordnet ist und die Durchgangsbohrungen (8) für die Testnadeln (3) aufweist, und eine Einstelleinrichtung (5), mittels derer die Position der Leiterplatine (6) in Bezug auf die Kolbenpositionen der Testnadeln (3) so einstellbar ist, daß bei einer Bewegung der Nadelträgerplatte (1) auf die Leiterplatine (6) zu die Kolben (3a) der Testnadeln (3) exakt auf die Testpunkte auf der Leiterplatine (6) treffen. Die Einstelleinrichtung umfaßt insbesondere Mittel, die an der Leiterplatine (6) fixierbar sind und die in der Leiterplatinenträgerplatte (4) in Richtung einer zu der Leiterplatinenebene parallelen Ebene verstellbar verankert sind.

## Beschreibung

Die vorliegende Erfindung betrifft einen Testadapter gemäß dem Oberbegriff des Anspruchs 1.

### [Stand der Technik]

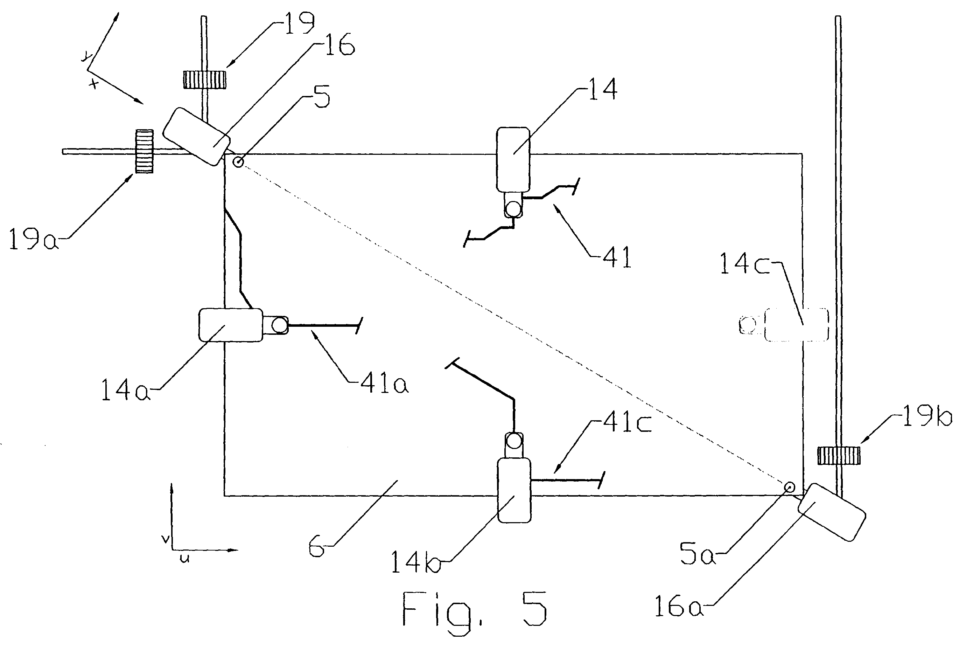

Testadapter werden bei der Serienfertigung bestückter und unbestückter Leiterplatinen im Bereich von Test und Reparatur eingesetzt und dienen der gleichzeitigen Kontaktierung einer großen Vielzahl von Kontaktstellen der Leiterplatine mit einem automatischem Testsystem. Einen typischen Aufbau für einen herkömmlichen Testadapter zeigt die Figur 3. Der Testadapter weist eine Nadelträgerplatte 1 und an dieser Platte montierte Hülsen 2 sowie auswechselbar eingesteckte Testnadeln 3 auf. Die Testnadeln 3 besitzen eine als Kolben 3a bezeichnete Spitze zum Kontakt mit Testpunkten 7 einer Leiterplatine 6. Die Leiterplatine 6 ist auf einer Leiterplatinenträgerplatte 4 des Testadapters mit Aufnahmestiften 5 montiert. Gewöhnlich wird die Leiterplatine 6 durch Unterdruck oder durch eine hier nicht eingezeichnete Niederhaltetechnik gegen die Testnadeln 3 gedrückt, wobei im allgemeinen die Leiterplatinenträgerplatte 4 eine vertikale Bewegung in Richtung zur Nadelträgerplatte 1 ausführt.

Gewöhnlich werden je nach Testverfahren und Leiterplatinengröße gleichzeitig zwischen einigen hundert und einigen tausend Testnadeln 3 zugeordnete Testpunkte 7 auf der Leiterplatine 6 kontaktiert. Eine besonders hohe Wirtschaftlichkeit bietet dabei das In-Circuit Testverfahren, bei dem jedoch alle Netze einer bestückten Leiterplatte mit mindestens je einer, in wenigen Fällen auch mehreren Testnadeln kontaktiert werden müssen. Um eine zuverlässige Kontaktierung zu erreichen, werden auf der Leiterplatine bei Netzen mit nur oberflächenmontierten Bauteilen entweder spezielle Kontaktflächen (Testpads) vorgesehen, oder falls möglich, bestehende Durchkontaktierungen verwendet. Bei den in der Verbreitung abnehmenden Bauteilen in Durchstecktechnik können auch die Bauteilanschlußpunkte zuverlässig kontaktiert werden.

Die fortschreitende Miniaturisierung elektronischer Baugruppen erfordert einerseits eine Reduzierung des zur Kontaktierung erforderlichen minimalen Durchmessers von Testpads und Durchkontaktierungen, andererseits aber auch die Möglichkeit, bisher nicht kontaktierbare Kontaktbereiche z.B. von oberflächenmontierten Bauteilen oder dünne Leiterbahnen zu kontaktieren. Gerade bei der zweiten Anforderung werden sehr hohe Anforderungen an die Positionsgenauigkeit gestellt.

Die Größe der erforderlichen Testkontaktflächen hängt dabei im wesentlichen von der Summe der Toleranzen der Testnadeln, der Führungen des Adaptersystems und von der Maßhaltigkeit der Leiterplatine 6 ab. Die Einflußfaktoren ihr die Größe der erforderlichen Testfläche auf der Leiterplatine 6 läßt sich in drei Gruppen unterteilen:

Eine erste Fehlergruppe, die einen erheblichen Anteil am Gesamtfehler hat, stellt der montagebedingte Versatz der Hülsen 2, die die Testnadeln 3 aufnehmen, sowie das Taumelspiel der Testnadeln 3 selbst dar.

Die zweite wichtige Fehlergruppe betrifft die herstellungs- oder verarbeitungsbedingte Abweichung der Maßhaltigkeit der Leiterplatine 6. Die wichtigsten Auswirkungen sind der Versatz zwischen Bohrbild und Leiterbahnbild, der sich direkt als Versatz der Testpunkte gegenüber den Aufnahmebohrungen der Leiterplatte 6 widerspiegelt, sowie eine Dehnung oder Schrumpfung sowohl der gesamten Leiterplatine 6 als auch des Leiterbahnbildes gegenüber dem Bohrbild. Ferner stellt ein Winkelversatz zwischen Bohrbild und Leiterbahnbild eine Fehlerquelle dieser zweiten Fehlergruppe dar.

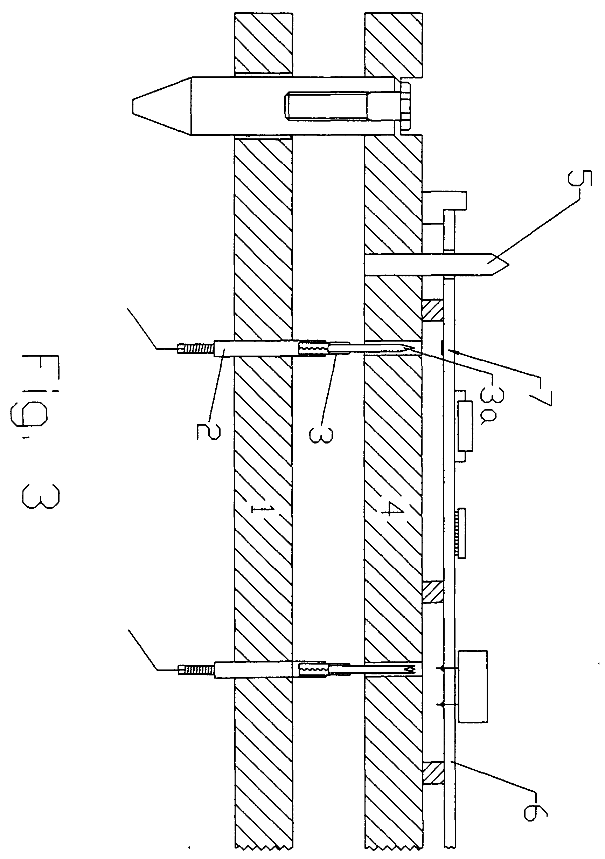

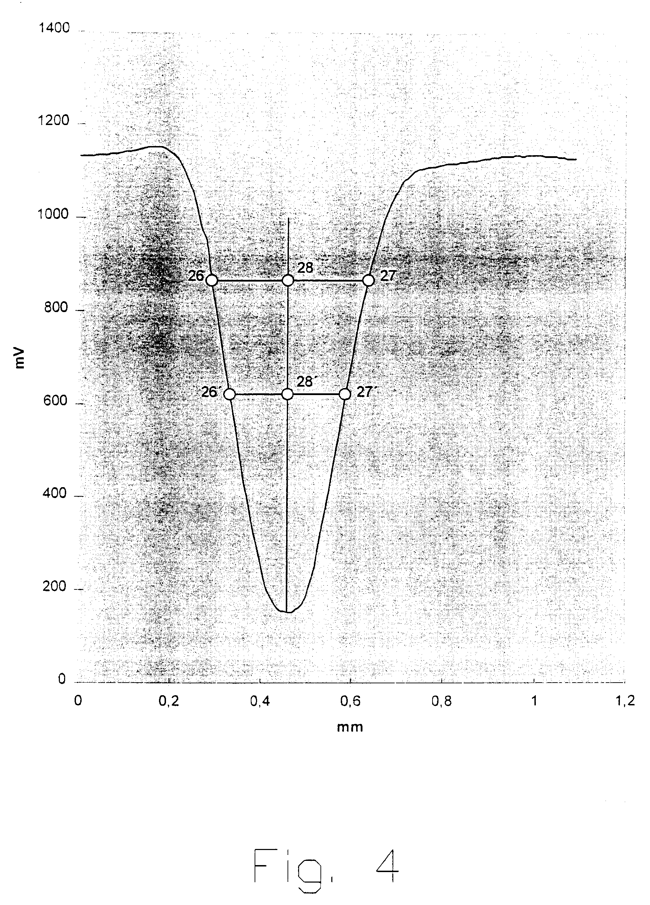

In Figur 2 ist die Auswirkung des Versatzes zwischen Bohrbild und Leiterbahnbild gezeigt. Dieser Versatz ist in Figur 2 an der nichtzentrischen Position des Bohrlochs 24 bezogen auf den die Bohrung umgebenen Kupferring 21 erkennbar. Der gleiche Versatz bedingt, daß die eingezeichnete Strecke a zwischen Aufnahmeloch 20, durch das die Leiterplatine 6 auf der Leiterplatinenträgerplatte 4 befestigt wird, und dem Testpunkt 23 eine Abweichung aufweist und damit eine relativ zu der Mitte des Aufnahmelochs 20 ausgerichtete Testnadel 3 den Kontaktpunkt 23 je nach Kontaktpunktgröße entweder nicht mittig oder komplett nicht trifft.

Die dritte Fehlergruppe ergibt sich aus der Führung der Leiterplatine 6 über die fest positionierten Aufnahmestifte 5. Zum Ausgleich der Toleranzen von Aufnahmestift 5 und der Aufnahmebohrung 20 in der Leiterplatine 6, sowie zum Ausgleich der oben genannten Fehler in der Maßhaltigkeit der Leiterplatine 6 muß der Durchmesser der Aufnahmestifte 5 immer so gewählt werden, daß stets eine Spielpassung erreicht wird. Eine derartige Spielpassung bedingt zwangsläufig einen möglichen Positionsfehler.

Bei allen Fehlerquellen muß zusätzlich berücksichtigt werden, daß insbesondere bei hoher Fertigungsstückzahl Leiterplatinen meist von vielen verschiedenen, international produzierenden Herstellern bezogen werden, so daß die Möglichkeit einer engen Zusammenarbeit mit dem Hersteller zur Reduzierung der Toleranzen erschwert ist und in der Praxis kaum erfolgt. Weiterhin sind für einen laufenden Fertigungsprozeß idealerweise automatische oder zumindest leicht handhabbare halbautomatische Korrekturverfahren erforderlich, da ein kompliziertes manuelles Korrigieren auftretender Toleranzen nicht mit den Anforderungen der laufenden Serienfertigung vereinbar ist.

Testadapter, die insbesondere auf die Korrektur der oben genannten zweiten Fehlergruppen, d.h. der Platinenversatzfehler zielen, sind aus mehreren Patenten bekannt. In der US 4820975 ist ein Testadapter mit verschiebbaren Nadelträgerplatten beschrieben, bei dem durch das Ausmessen von Bezugsmarken über Videokameras der Versatz bestimmt wird und dieser Fehler dann automatisch über die xy-verschiebbare Nadelträgerplatte angepaßt wird.

Eine Alternative zu dieser technisch aufwendigen Lösung stellt der später in der US 5,321,351 beschriebene Testadapter dar, bei dem die Aufnahmestifte für die Leiterplatine justierbar montiert sind und bei dem für ein jeweiliges Fertigungslos von Leiterplatinen eine Justage ebenfalls unter Auswertung von Bezugsmarken mit Videokameras erfolgt.

Dieser Testadapter weist jedoch den Nachteil auf, daß der Einstellmechanismus für die Einstellstifte nur für eine einzelne Einstellungen mittels der speziellen Justierplatine geeignet ist, so daß manuelle oder automatische Anpassungen innerhalb einer Serie von Leiterplatinen nicht vorgenommen werden können. Ein zusätzlicher Nachteil ergibt sich auf Grund der in der Nadelträgerplatte befestigten Aufnahmestifte, wenn bedingt durch kleine Aufnahmelöcher Aufnahmestifte mit kleinem Durchmesser benötigt werden. In diesem Fall bedingt das ungünstige Verhältnis zwischen Durchmesser und Länge des Aufnahmestiftes eine sehr geringe Stabilität. Ein weiterer Nachteil dieser Ausführung ist, daß in der Nadelträgerplatte befestigte Aufnahmestifte beim Ansaugen des Adapters schlagartig durch die Leiterplatine hindurchstoßen und so zur Erfüllung der Arbeitssicherheitsvorschriften zusätzliche Schutzmaßnahmen erfordern.

Diese drei genannten Nachteile wurde dann in der Weiterbildung gemäß US 5,408,189 beseitigt. Hier befinden sich die Aufnahmestifte fest in der Leiterplatinenträgerplatte und diese kann über Antriebselemente relativ zur Nadelträgerplatte kontinuierlich verstellt werden. Bei dieser Ausführung müssen jedoch die Durchgangslöcher der Federkontaktstifte durch die Leiterplatinenträgerplatte besonders groß sein, so daß z.B. ein Nachführen der Kolben in der Leiterplatinenträgerplatte konstruktionsbedingt nicht möglich ist.

Alle drei beschriebenen Testadapter basieren auf dem Prinzip, daß die Positionen der Leiterplatine und die der Aufnahmebohrungen der Federkontaktstifte in der Nadelträgerplatte relativ zueinander verschoben werden und auch die Referenzmessung über Videokameras zwischen Nadelträgerplatte und Leiterplatine erfolgt. Die zu Beginn beschrieben Fehleranteile durch Montageversatz, Taumelspiel der Nadel und Spiel der Aufnahmelöcher werden so nicht berücksichtigt und begrenzen damit die erzielbare Positionsgenauigkeit. Weiterhin ist zum Einrichten eine spezielle Justierplatine (golden board) und ein komplizierter Einrichtprozeß erforderlich, der z.B. ausführlich in der US 5,321,351 beschrieben wird. Da die spezielle Justierplatine weiterhin nicht zum üblichen Lieferumfang des Leiterplatinenherstellers gehört, ergeben sich u.U. zusätzlich erhebliche Beschaffungsprobleme.

Ein weiterer Nachteil bei allen drei benannten Lösungen liegt in der Art der Versatzmessung über spezielle Bezugsmarken begründet. Während die in den Anwendungen zum Teil beschriebenen Bezugsmarken zur Leiterplatinenherstellung sich früher oft im nutzbaren inneren Leiterplatinenrandbereich befanden, wurden diese Bezugsmarken im Zuge der Miniaturisierung inzwischen fast durchgängig auf den nur bei der Leiterplatinenherstellung verfügbaren äußeren Randbereich verlegt, der bei Fertigstellung der unbestückten Leiterplatine abgefräst wird.

Auch die in den Patentschriften US 5,321,351 und US 5,408,189 erwähnten alternativen Bezugsmarken - bekannt sind z.B. solche Bezugsmarken für die Korrektur der Bauteilbestückung - sind meist nur auf der Leiterplatinenoberseite, sehr oft nicht jedoch auf der für die Prüfkontaktierung am häufigsten vorgesehenen Leiterplatinenunterseite verfügbar. Zur universellen Anwendbarkeit des Verfahrens wäre damit bei allen Platinenlayouts die Forderung nach geeigneten Bezugsmarken auf jeder Adapterkontaktierseite erforderlich. Dies macht eine Änderung der bestehenden und bekannten Konstruktionsrichtlinien für Leiterplatinen erforderlich. Derartige Richtlinienänderungen sind erfahrungsgemäß nur sehr schwer und langwierig durchsetzbar.

Ein weiterer Nachteil der benannten Lösungen resultiert aus der Notwendigkeit des Einsatzes von Videokameras bei kleinen und damit räumlichen sehr engen Leiterplatinen. Derartige Videokameras sind bei kleinen Abmessungen sehr kostenintensiv. Auch die bei den bestehenden Lösungen vorgeschlagenen Lichtleiter mit umsteckbaren Videokameras stellen u.a. deswegen ein hohen Aufwand dar, da für eine Bildübertragung nicht ein einzelner Lichtleiter, sondern nur ein Faserbündel mit sehr vielen Einzellichtleitern geeignet ist. Trennbare Steckverbindungen für Faserbündel sind ebenfalls sehr kostenintensiv.

Technisch bekannt für Anwendungen beim Test unbestückter Baugruppen sind durch das deutsche Gebrauchsmuster DE 29616 272 U1 und durch die europäische Patentanmeldung EP 0 859 239 A2 Lösungen, in denen über gemeinsam verschiebbare Aufnahmestifte eine Korrektur der Verschiebung erfolgt. Da beim Test unbestückter Leiterplatten aber nicht alle genannten Fehlergruppen relevant sind, ist eine direkte Übertragbarkeit der Lösungen auf den Test bestückter Leiterplatten nicht möglich. Einer der wichtigsten Unterschiede ist, daß bestückte Leiterplatten durch das Löten einem zusätzlichen Wärmeprozeß ausgesetzt sind, der zur Dehnung, Schrumpfung oder Verzug der bestückten Leiterplatine führen kann. Die bei beiden Lösungen auf einer gemeinsamen Platte befestigten Aufnahmestifte sind nicht unabhängig voneinander verschiebbar und können damit einen Teil der Fehler nicht korrigieren. Ein weiterer Nachteil an beiden Lösungen ist, daß eine zusätzliche Platte im Nadelfeld des Prüfadapters notwendig wäre, die bei der Anwendung in Prüfadaptern für bestückte Leiterplatinen erhebliche Nachteile aufweist.

Die Aufgabe der vorliegenden Erfindung ist es, einen Testadapter bereitzustellen, bei dem die vorliegenden Nachteile beseitigt werden und durch gleichzeitige Korrektur aller wichtigen Fehlerquellen die Positionen der Kolben der Testnadeln für einen Kontakt mit Testpunkten auf einer Leiterplatine genauer eingestellt werden können.

Erfindungsgemäß wird zur Lösung dieser Aufgabe ein Testadapter mit den Merkmalen des Anspruchs 1 bereitgestellt, wobei sich vorteilhafte Ausgestaltungen aus den Unteransprüchen ergeben.

Insbesondere umfaßt der erfindungsgemäße Testadapter eine Einstelleinrichtung mit Mitteln, die an der Leiterplatine fixierbar sind und die in der Leiterplatinenträgerplatte in Richtung einer zu der Leiterplatinenebene parallelen Ebene verstellbar verankert sind, sowie eine wiederum an der Leiterplatinenträgerplatte montierte Meßeinrichtung, die durch getrennte Meßpositionen für x- und y-Anteil des Versatzes die Nutzung von beliebigen Leiterbahnen als Bezugsreferenz erlauben. Vorteilhaft an dieser Einstelleinrichtung des Testadapters ist, daß die Leiterplatine relativ zu den Kolben der Testnadeln und relativ zu der Leiterplatinenträgerplatte mit den für die Testnadeln vorgesehenen Durchgangsbohrungen verschiebbar ist. Hierdurch ist es möglich, die Durchgangsbohrungen in der Leiterplatinenträgerplatte mit einem sehr geringen Spiel auszuführen, so daß eine Führung der Testnadeln durch die Durchgangsbohrungen möglich ist, wodurch das Taumelspiel der Testnadeln erheblich reduziert werden kann.

Durch die gleichzeitige Korrektur aller wichtigen Fehler kann dann zum erstmaligen Einrichten das z.B. über ein Meßmikroskop leicht erfaßbare Kontaktierergebnis einer beliebigen Leiterplatte aus der laufenden Produktion verwendet werden, so daß die Notwendigkeit einer speziellen Justierplatine entfällt. Ein weiterer Vorteil ergibt sich aus der Montage der Aufnahmestifte in der Leiterplatinenträgerplatte, da so durch die geringe Länge der Aufnahmestifte auch bei geringem Durchmesser eine ausreichende Stabilität gewährleistet ist.

Vorteilhafterweise umfassen die Mittel zwei Aufnahmestifte, deren eines Ende jeweils in Bohrlöcher der Leiterplatine eingreifen kann und deren anderes Ende jeweils über einen Einstellmechanismus verstellbar in der Leiterplatinenträgerplatte verankert ist. Dabei kann ein Aufnahmestift in zwei senkrechten Richtungen parallel zu der Leiterplatinenebene mittels des Einstellmechanismus bewegbar sein, und der andere Aufnahmestift in eine Richtung mittels des Einstellmechanismus bewegbar sein und in der Richtung senkrecht dazu über ein federndes Element geführt bewegbar sein. Vorteilhaft an dieser Ausbildung ist, daß das Spiel der Aufnahmestifte in den Aufnahmelöchern der Leiterplatine ausgeglichen werden kann, so daß auch Fehler der vorstehend genannten dritten Fehlergruppe korrigiert werden können.
Ferner kann erfindungsgemäß die Bewegung der Einstelleinrichtung über einen Motor erfolgen, und eine Steuerung für den Motor vorgesehen sein, die den Motor abhängig von Signalen der Sensoren ansteuert, so daß die Einstelleinrichtung in einem automatischen Regelkreis verstellt wird. Vorteilhaft an dieser Ausbildung ist, daß für jede Leiterplatine mittels der Sensoren Fehler erfaßt werden können, und die Einstelleinrichtung automatisch mittels des Motors eingestellt werden kann.

Ferner kann die Bewegung der Einstelleinrichtung auch zusätzlich oder allein über manuell mit Skalen versehene Stellräder erfolgen. Diese Ausbildung erlaubt eine besonders einfache und reproduzierbare Einstellung der Leiterplatine relativ zu den Testnadeln. Somit sind in diesem Fall die Aufnahmestifte der Einstelleinrichtung nicht nur einmalig justierbar, sondern sie können kontinuierlich nachgeregelt werden.

In einer weiteren Ausbildung des erfindungsgemäßen Testadapters sind in den Durchführungen der Leiterplatinenträgerplatte Führungshülsen für die Testnadeln vorgesehen. Ferner kann auf der Leiterplatine zugewandten Seite der Leiterplatinenträgerplatte eine Führungsplatte angeordnet sein, die bei den Durchgangsbohrungen der Leiterplatinenträgerplatte Führungsbohrungen für die Testnadeln aufweist. Durch diese Maßnahmen können die Fehler der ersten Fehlergruppe (Montagetoleranzen und Taumelspiel der Nadeln) korrigiert werden.

Die Sensoren des erfindungsgemäßen Testadapters können Sensoren sein, die für eine zumindest eine Richtung die Position einer Linie oder einer Linienkante erfassen. Dies können bewegbare Punktsensoren oder bewegbare optische Reflexsensoren sein, wobei die Bewegung der Sensoren über die Bewegung der Nadelträgerplatte auf die Leiterplatine zu erfolgen kann. Derartige Punkt- oder Reflexsensoren sind räumlich sehr klein und wesentlich kostengünstiger als Bildaufnehmer, die ein Referenzbild aufnehmen. Durch die Bewegung des Sensors und die mathematische Auswertung des Signals dieses Sensors können Meßfehler erkannt werden und gleichzeitig Veränderungen der optischen Parameter, wie z.B. ein anderer Farbton des Lötstoplackes oder ein anderes Basismaterial der Leiterplatine automatisch erkannt und berücksichtigt werden. Eine andere Ausführungsvariante der Sensoren ergibt sich durch fest an der Leiterplatinenträgerplatte montierten leitenden Flächen, so daß der Versatzes über elektrische Parameter wie Kapazität, Induktivität oder kapazitive oder induktive Kopplung zwischen einer Leiterbahn der Leiterplatine und der am Testadapter fixierten Fläche ausgewertet werden kann.

Vorteilhafterweise sind die Sensoren jeweils in der Nähe der Mitte der Leiterplatine angeordnet. An dieser Anordnung ist vorteilhaft, daß neben dem Versatz des Bohrbildes zum Leiterbahnbild auch eine optimale Anpassung an Dehnung oder Schrumpfung der Leiterplatine erfolgen kann. Insbesondere kann hierdurch bei linearem Verlauf einer Dehnung oder Streckung eine optimale Korrektur erzielt werden.

Des weiteren können mit den Sensoren des erfindungsgemäßen Testadapters bestimmte Leiterbahnen oder Leiterbahnkanten der Schaltungsanordnung der Leiterplatine örtlich erfaßbar sein. Hierzu werden vorteilhafterweise die Sensoren und die Einstelleinrichtung mit einer Auswerteinrichtung verbunden, die die von den Sensoren erfaßten Positionen bestimmter Leiterbahnen, Leiterbahnkanten der Schaltungsanordnung der Leiterplatine mit den entsprechenden theoretischen Positionen vergleicht, und so den Versatz des tatsächlichen Leiterbahnbildes ermittelt und an die Einstelleinrichtung überträgt.

Durch den Vergleich der tatsächlich erfaßten Positionen bestimmter Teile der Schaltungsanordnung mit den theoretischen Positionen, die sich beispielsweise aus dem CAD-Daten ergeben können, ist es möglich, den Versatz ohne das Vorsehen von speziellen Referenzmarken zu ermitteln und damit zu korrigieren. Ferner können dadurch, daß die Sensoren Leiterbahnen oder Leiterbahnkanten der Schaltungsanordnung messen, nahezu beliebig viele optische Sensoren an frei wählbaren Stellen montiert werden, ohne daß auf der Leiterplatine an diesen Positionen spezielle Referenzmarken vorgesehen sein müßten. Dadurch können wahlweise weitere Fehler, wie z.B. Winkelfehler erfaßt und korrigiert werden oder auch bei Leiterplatinen mit großen Abmessungen mehrere Positionen vermessen werden, und so z.B. der Test der linken Leiterplatinenhälfte mit anderer Korrektur als der rechten Leiterplatinenhälfte erfolgen.

Ferner kann der erfindungsgemäße Testadapter drei Sensoren umfassen zum Erfassen des Versatzes und der Verdrehung des Leiterbahnbildes zu den Bohrlöchern.

Des weiteren wird erfindungsgemäß ein Testadaptersystem bereitgestellt, bei dem zwei erfindungsgemäße Testadapter aufbeiden Seiten der zu testenden Leiterplatine angeordnet sind, wobei die jeweiligen Einstelleinrichtungen eine unabhängige Einstellung der beiden Testadapter in Bezug auf die jeweiligen Schaltungsanordnungen auf den jeweiligen Seiten der Leiterplatine ermöglichen.

Die vorliegende Erfindung wird nun anhand von Ausführungsbeispielen mit Bezug zu den Zeichnungen erläutert.

### Beispiele

Figur 1 zeigt einen Testadapter gemäß einem Ausführungsbeispiel der vorliegenden Erfindung,
Figur 2 beschreibt die Auswirkung eines Versatzes zwischen Leiterbahnbild und Bohrbild,
Figur 3 zeigt schematisch den Aufbau eines Testadapters des Standes der Technik,
Figur 4 zeigt Ergebnisse einer Beispielmessung mit Reflexsensoren eines Ausführungsbeispiels der Erfindung,
Figur 5 zeigt die Anordnung der Sensoren zur Erfassung verschiedener Fehlerursachen,
Figur 6 zeigt eine Anordnung der Aufnahmestifte mit einem in zwei Achsrichtungen verstellbarem Stift und einem in eine Achsrichtung verstellbaren und in der zweiten Achsrichtung gefederten Aufnahmestift
Figur 7 zeigt als Detail den Aufbau der Sensoren gemäß einem Ausführungsbeispiel der Erfindung,
Figur 8 zeigt den Aufbau der Verstellmechanik der Einstelleinrichtung eines Ausführungsbeispiels der Erfindung,
Figur 9 zeigt die Kopplung der Verstellmechanik mit einem Grundgerät,
Figur 10 zeigt eine alternative kapazitive Messung,
Figur 11 zeigt die Nadelnachführung mit Einsatzhülsen,
Figur 12 zeigt eine Nadelnachführung mit getrennter Führungsplatte,
Figur 13 zeigt eine Lösung der Versatzkorrektur bei doppelseitiger Kontaktierung,
Figur 14 zeigt eine mögliche Nadelkontaktierung auf dem Anschlußpad eines oberflächenmontierten Bauteils.
Figur 15 zeigt den Ablauf von Messung und Korrektur in Verbindung mit dem erfindungsgemäßen Testadapter

Der typischen Aufbau eines Adaptersystems mit der Nadelträgerplatte 1 und den in dieser Platte montierten Hülsen 2 sowie auswechselbar eingesteckten Federkontaktstiften 3, der Leiterplatinenträgerplatte 4 mit Aufnahmestiften 5 für die zu prüfende, mit Bauteilen bestückte Leiterplatine 6 wird in **Figur 3** dargestellt.. Die Leiterplatine 6 wird dabei durch Unterdruck oder durch eine hier nicht eingezeichnete Niederhaltetechnik gegen die Nadeln gedrückt, wobei im allgemeinen die Leiterplatinenträgerplatte 4 eine vertikale Bewegung in Richtung zur Nadelträgerplatte 1 ausführt.

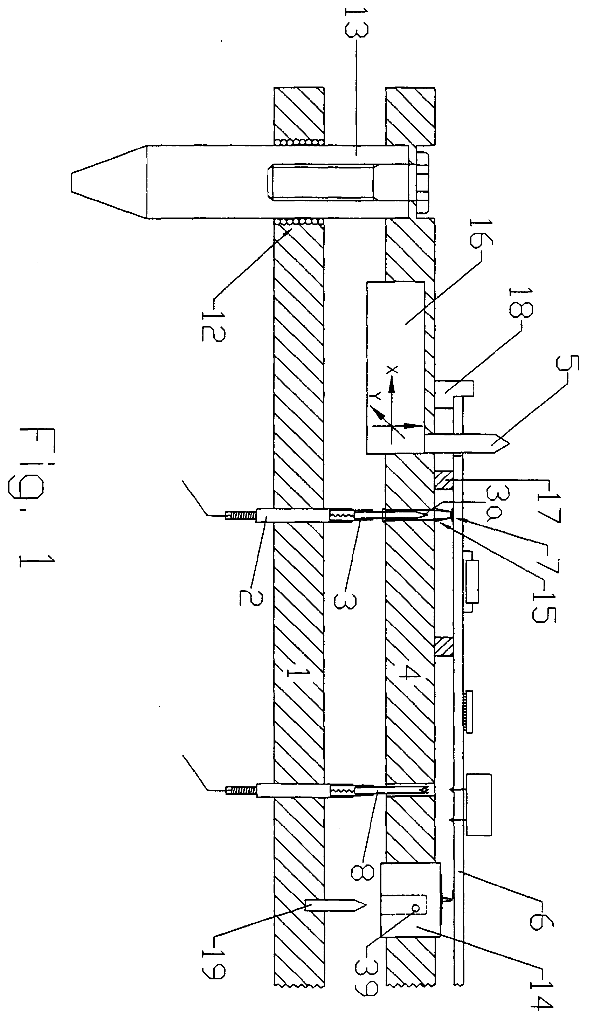

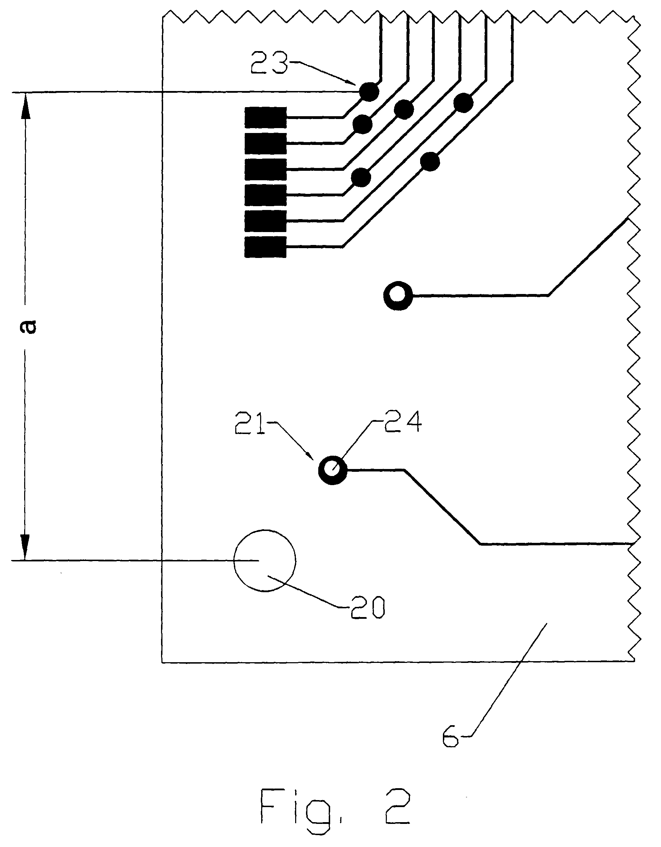

**Figur 1** stellt eine erfindungsgemäße Erweiterung des in Figur 3 bereits beschriebenen Grundkonzeptes dar, in dem der bestehende Aufnahmestift durch einen in zwei Richtungen verstellbaren Aufnahmestift 5 ersetzt wird. Optional sind mindestens zwei Sensoren 14 angebracht. Weiterhin werden die normalerweise für kleine Testpunkte vorgesehenen spitzen und konisch zulaufenden Nadeln durch eine spezielle Führungshülse 15 nachgeführt. In Verbindung mit einer präzisen Nachführung ist es weiterhin zweckmäßig, die Adapterplatten zueinander durch sehr stabile Führungsstifte 13 und hochwertige Linearlager 12 zu lagern.

Der Aufnahmestift 5 greift einerseits in ein Aufnahmeloch 20 (vergleiche Figur 2) der Leiterplatine 6 ein und ist andererseits über einen Einstellmechanismus verstellbar in der Leiterplatinenträgerplatte 4 verankert. Durch den Einstellmechanismus kann die Position der Leiterplatine 6 in Bezug auf die Positionen der Kolben 3a der Testnadeln 3 so eingestellt werden, daß bei einer Bewegung der Nadelträgerplatte 1 auf die Leiterplatine 6 zu die Kolben 3a der Testnadeln 3 exakt auf bestimmte Testpunkte auf der Leiterplatine 6 treffen. Zum Einstellen der Position der Leiterplatine 6 ist der Aufnahmestift 5 in Richtung einer zu der Leiterplatinenebene parallelen Ebene verstellbar in der Leiterplatinenträgerplatte 4 verankert. Damit wird beim Einstellen der Position der Leiterplatine 6 nur der Aufnahmestift 5 zusammen mit der Leiterplatine 6 bewegt, wobei die Leiterplatinenträgerplatte 4 stationär bleibt. Vorzugsweise wird die Leiterplatine 6 von zwei Aufnahmestiften 5 aufgenommen, die jeweils in der Leiterplatinenträgerplatte 4 verstellbar verankert sind.

Durch einen zweckmäßigerweise automatischen Antrieb oder über einen mit Skalenrädern versehenen Handantrieb lassen sich die beiden Aufnahmestifte 5 im Bereich von wenigen Zehntel Millimeter verschieben. Hierbei ist es zweckmäßig, einen Aufnahmestift 5 in beiden Achsen über ein Antriebssystem zu bewegen und beim zweiten Aufnahmestift 5 eine Achse über das Antriebssystem, eine zweite über ein federndes Element geführt zu bewegen.

Die Sensoren 14 sind bei Ausführung als optische Punktsensoren zweckmäßigerweise in die Leiterplatinenträgerplatte 4 eingelassen und so angeordnet, daß sie jeweils für eine Richtung die Position einer aus den CAD-Daten bekannten Leiterbahn bestimmen. Hierzu erfolgt beim Absenken des Adapters eine senkrechte Bewegung des Sensors 14 über die zu messende Leiterbahn.

Je nach Anzahl der Sensoren 14 lassen sich aus den Abweichungen der Leiterbahnpositionen nur Versatz, Versatz und Drehung oder Versatz, Drehung und Streckungen der Platine erfassen und über die verschiebbaren Aufnahmestifte 5 kompensieren.

Eine einfache Lösung zur optischen Erfassung stellen sogenannte Reflexsensoren dar, die durch ihre Verwendung speziell für die Erkennung von Strichcodes als kostengünstige Standardbauteile verfügbar sind. Diese Reflexsensoren enthalten eine auf einen optischen Meßpunkt von etwa 0,2mm Durchmesser über Linsen ausgerichteten optischen Sender und Empfänger und erfassen so den optischen Reflexionswert an dem genau definierten Meßpunkt.

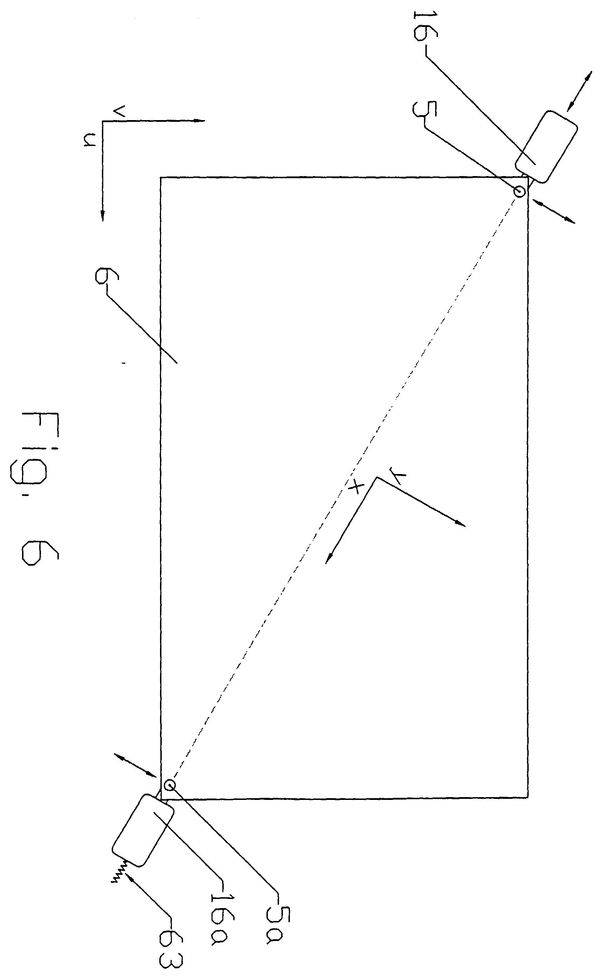

Als Meßobjekt können beliebige Leiterbahnen oder Leiterbahnkanten verwendet werden, so daß das Meßverfahren nicht auf das Vorhandensein von Bezugsmarken angewiesen ist. Wird ein Reflexsensor z.B. über eine Leiterbahn bewegt, ergibt sich der in **Figur 4** dargestellte, vom Sensor 14 als Spannungswert wiedergegebene Helligkeitsverlauf. Hier gibt ein hoher Spannungswert geringe Reflexion, ein niedriger hohe Reflexion wieder.

Zur Auswertung kann z.B. über einfache mathematische Berechnungen bezogen auf einen oder mehrere Spannungswerte der Mittelpunkt 28 der Verbindungslinie 26, 27 ermittelt werden. Aus dem zugehörigen Millimeterwert auf der x-Achse des Diagrams läßt sich dann unmittelbar die Position der Leiterbahn ermitteln.

Durch die Vielzahl der auswertbaren Meßpunkte (z.B. zusätzlich 26' und 27') ist es weiterhin möglich, durch Verschmutzung oder Kratzer erzeugte Fehlmessungen automatisch zu erkennen und dies bei der automatischen Korrektur zu berücksichtigen.

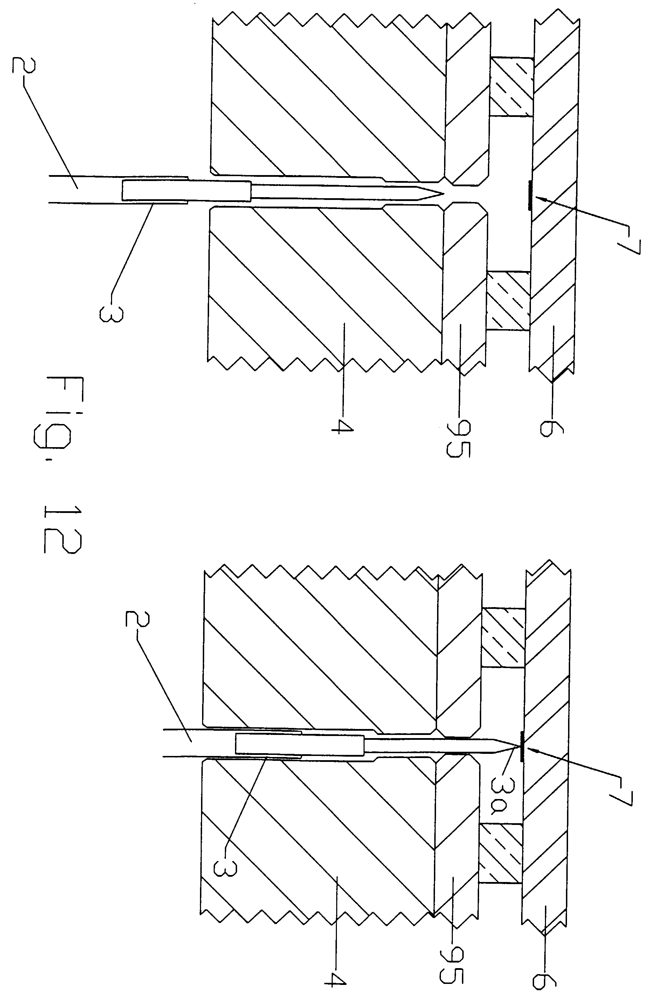

Zur Nachführung der Nadeln 3 werden zweckmäßig erfindungsgemäß verbesserte Führungen durch spezielle Führungsbuchsen 15 in Figur 3 oder eine individuelle Führungsplatte 95 (Figur 12) verwendet, die eine präzisere Führung als eine reine Nachführung durch verjüngten Bohrdurchmesser in der Leiterplatinenträgerplatte 4 bieten, aber nicht mit dem Nachteil hoher Kosten und doppelter Kontaktierstelle der zweistufig geführten Federkontaktstifte (gemäß dem bereits oben erwähnten US Patent 5,510,722) behaftet sind.

Ein wesentlicher Vorteil der vorliegenden Erfindung ist, daß alle wichtigen Fehlerquellen bei der Nadelpositionierung von Prüfadaptern gleichzeitig kompensiert werden können:
a) der Versatz zwischen Leiterbahnbild und Bohrbild durch Messung und Korrektur des Versatzes
b) Fehlerquellen durch die Nadelführung über Nadelnachführung in der Leiterplatinenträgerplatte oder einer zusätzlichen Führungsplatte oder die Verwendung von zweistufig aufgebauten Nadeln
c) Fehler durch Toleranzen der Passung Aufnahmeloch und -stift durch einen in eine Richtung gefedert geführten Aufnahmestift
d) Minimierung der Fehler durch Streckung oder Schrumpfung der Leiterplatte durch Positionierung der Sensoren in der achsbezogenen Mitte der Platine
c) Zusätzliche Kompensation von Winkelfehlern durch mindestens einen weiteren Reflexsensor

Weiterhin kann zur Erzielung einer sehr hohen Genauigkeit das erstmalige Einrichten mit Hilfe einer Musterleiterplatine, d.h. ohne zusätzliche Justierhilfen erfolgen. Da mit Ausnahme des Versatzes zwischen Leiterplatine 6 und Aufnahmestiften 5 weitgehend konstante Fehleranteile (z.B. durch den Montage- und Bohrprozeß) die Justage beeinflussen, kann jetzt der Versatz der Einstichpunkte der Nadelkolben 3a in die Leiterplatine 6 z.B. über ein Meßmikroskop einmalig als Abweichung an mehreren Bezugsstellen ausgemessen werden und als Korrekturwert in den Regelprozeß einfließen.

**Figur 5** zeigt die Anordnung von verstellbaren Aufnahmestiften 5 und Sensoren 14 zur Kompensation des Leiterbildversatzes und die optimierte Anpassung an Schrumpfung oder Dehnung sowie der Ausgleich der aufnahmelochbedingten Fehler. Zur Beschreibung werden zwei getrennte Koordinatensysteme bezeichnet. Das Koordinatensystem XY wird durch die diagonale Verbindung der Aufnahmestifte 5 bestimmt, das Koordinatensystem UV ist rechtwinklig zu der zu kontaktierenden bestückten Leiterplatte 6.

Die bestückte Leiterplatine 6 wird auf die Aufnahmestifte 5 und 5a gelegt und durch die gefederte Aufnahme 16a rechts unten in X-Richtung in Position gehalten. Gegenüber den Aufnahmestiften ergibt sich ein Gesamtversatz, der sich als Summe des Leiterbahnversatzes und des Aufnahmelochversatzes ergibt. Dieser Versatz wird für die U-Richtung am Sensor 14 durch Ausmessen der Leiterbahnposition 41, für die V-Richtung am Sensor 14a durch Ausmessen der Leiterbahnposition 41a bestimmt und über die bekannten Koordinaten der Aufnahmestifte 5, 5a und Sensoren 14 in eine Abweichung in X und Y-Richtung umgerechnet.

In **Figur 6** wird deutlich, wie durch zwei verstellbare Achsen auf der einen Seite und eine verstellbare und eine gefederte Achse die oben genannten Fehler der dritten Fehlergruppe berücksichtigt werden. Durch diese Anordnung wird auch bei schwankendem Abstand der Aufnahmelöcher durch die Feder die Leiterplatine 6 immer in einer definierten Position gehalten. Der her entstehende Fehler wird so automatisch bei der Versatzkorrektur mit kompensiert.

Bei einem Fehler in Y-Richtung erfolgt die Verstellung durch beide Y-Stellglieder 19 und 19b (Figur 5) in die gleiche Richtung. Ein Fehler in X-Richtung wird durch das X-Stellglied 19a in Verbindung mit der gefederten zweiten X-Führung 16a ausgeglichen.

Bei zusätzlichen Fehlern durch Dehnung oder Schrumpfung ist es hier eine zweckmäßige Korrekturstrategie, die Position so einstellen, daß in der Mitte der Leiterplatine 6 Kontaktpunkte mittig kontaktiert werden und die äußeren Kontaktpunkte gegenläufig, aber gleichmäßig versetzt kontaktiert werden. Diese Strategie wird automatisch erfüllt, wenn die Sensoren in der Mitte der Leiterplatine 6 angeordnet sind und wird erfindungsgemäß unterstützt, da beliebige Leiterbahnsegmente als Referenz ausgewählt werden können und damit eine achsenbezogene Mittenpositionierung einfach zu realisieren ist.

Ein optionaler dritter Sensor 14b erlaubt die zusätzliche Erkennung einer Drehung, da der Unterschied im Versatz zwischen Sensor 14 und 14b ein direktes Maß zur Bestimmung dieser Verdrehung wiedergibt. Selbst wenn keine geeigneten Positionen für die Sensoren 14 und 14 b gefunden werden können (ideal ist gleicher U-Wert), ist auch bei geringem Versatz der U-Werte von Sensor 14 und Sensor 14b durch die Kenntnis der genauen Koordinaten eine ausreichend genaue Verdrehungsmessung möglich. Außerdem ist es möglich, an Stelle der Position 14b eine Position 14c zu wählen und dann die Verdrehungsmessung zwischen den Sensoren 14a und 14c durchzuführen.

Bei Leiterplatinen 6 mit großen Abmessungen oder großen, im Nutzen gefertigten Leiterplatinen 6 bietet es sich an, mehrere Sensorpaare oder -tripple so anzuordnen, daß jeweils ein Paar oder Tripple einem Bereich zugeordnet ist. Hier könnte der Test je nach Lage der Bauteile in zwei oder mehrere Stufen unterteilt werden und zwischen den Tests die Korrektur umgeschaltet werden.

Weiterhin fallen bei hoher Genauigkeitsanforderung auch durch Umgebungsbedingungen (Temperatur, Luftfeuchtigkeit) verursachte mechanische Veränderungen ins Gewicht. Daher ist es zweckmäßig, wahlweise Testsysteme und Prüfadapter in klimatisierten Bereichen zu betreiben oder Temperatur und Luftfeuchtigkeit meßtechnisch zu erfassen und dies bei der softwareunterstützten Berechnung der Korrektur zu berücksichtigen.

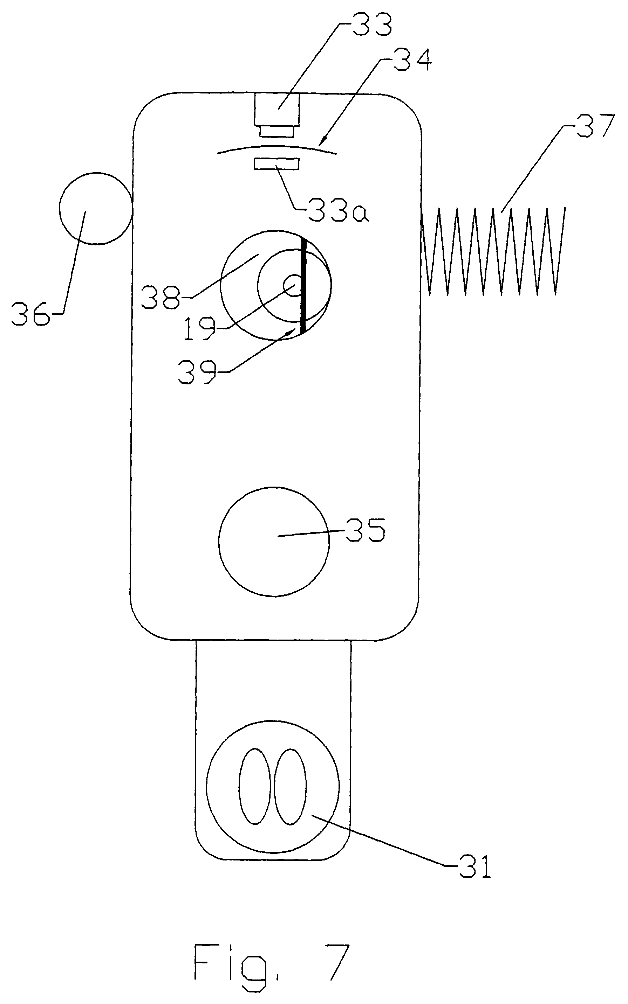

Eine zweckmäßige Ausführung des Versatzsensors wird in **Figur 7** beschrieben:

Der Versatzsensor besteht aus einer um die Drehachse 35 drehbaren Einheit mit optischem Reflexsensor 31, einer mechanischen Umlenkanordnung 38, 39 und optional aus einem einfachen Wegmeßsystem mit Gabellichtschranke 33 und 33a und einem Linienstreifen 34. Durch die Feder 37 und den Anschlagstift 36 wird der Sensor in Ruheposition gehalten, wobei die Position so festgelegt wird, daß sich der Sensormittelpunkt vor dem Beginn der ausgewählten Leiterbahn befindet.
Die zum Aufnehmen der Leiterbahnreflexionswerte erforderliche Drehbewegung kann wahlweise über einen eigenen Antrieb, aber auch über die Absenkbewegung des Prüfadapters erfolgen. Bei der zweiten Lösung, hier dargestellten und besonders einfachen Lösung bewirkt der in der Nadelträgerplatte 1 montierte spitz zulaufende Stift 19 (siehe auch Figur 1) beim Absenken über den Querstift 39 eine leichte Drehbewegung des Sensors 14. Dabei kann über die mechanischen Abmessungen die Drehbewegung so eingestellt werden, daß erst im zweiten Teil der Absenkbewegung die Messung erfolgt. In diesem Fall ist die Leiterplatine 6 dann schon fest gegen die Dichtung 18 und die Abstandshalter 17 gegengedrückt und liegt plan auf.

Die Position des Sensors 14 wird so gewählt, daß die Meßlinie eine komplette Leiterbahnbreite senkrecht zum Leiterbahnverlauf erfaßt. Die Meßwerte werden gespeichert und über ein rechnergesteuertes System ausgewertet.

Zur Triggerung des Meßsystems können zweckmäßig Impulse generiert werden, die linear zur Absenkbwegung erzeugt werden. Besonders zweckmäßig ist, diese Impulse direkt am Meßpunkt zu erzeugen, da so eine unterschiedlich schnelle Absenkung der Leiterplatinenträgerplatte 4 an verschiedenen Stellen keine Meßfehler bewirkt. Eine zweckmäßige Anordnung zur Erzeugung der Triggerimpluse stellt die Kombination einer Gabellichtschranke 33, 33a mit einem fest an der Leiterplatinenträgerplatte 4 montierten Linienstreifen 34 dar.

Grundsätzlich ist eine Positionskorrektur des Prüfadapters nur möglich, wenn die zu prüfende Leiterplatine 6 nicht an das Nadelfeld angesaugt oder angedrückt ist. Damit ergibt sich auf den ersten Blick ein zusätzlicher Zeitaufwand für ein erstes Ansaugen des Prüflings, Messen, Entlasten des Prüflings und Positionskorrektur.

Durch eine geeignete Anordnung des Meßablaufes läßt sich jedoch erreichen, daß dieser zusätzliche Zeitaufwand nur selten erforderlich ist. Hierbei wird mit ausgenutzt, daß die meisten Testsysteme eine Fehlkontaktierung auch meßtechnisch registrieren können und häufig Platinen der gleichen Produktioncharge einen ähnlichen Versatz haben.

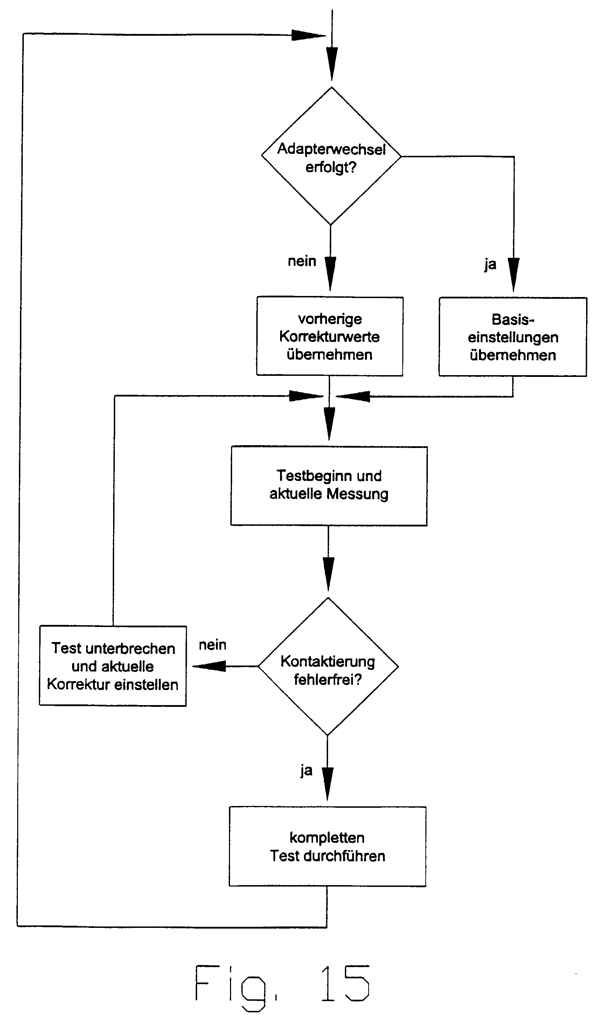

**Figur 15** beschreibt den Ablauf von Messung und Fehlerkorrektur.

Hier werden nach einem Wechsel des Prüfadapters, d.h. zu Beginn einer neuen Leiterplatinenserie, zunächst gespeicherte Basiseinstellungen übernommen. Ist die Kontaktierung mit dieser Einstellung fehlerfrei, läuft der Test ohne zeitliche Verzögerung zu Ende. Nur bei einem Kontaktierfehler erfolgt eine Korrektur auf Basis der aktuell ermittelten Korrekturwerte. Bei jeder weiteren Leiterplatineserie werden dann die Korrekturwerte der vorherigen Leiterplatine 6 übernommen.
Diese Verfahren ist, wie vorher erwähnt, insbesondere dann zweckmäßig, wenn Leiterplatinen 6 in Chargen gefertigt und in der Produktion verwendet werden. Hier ist dann zu erwarten, daß hintereinanderfolgende Leiterplatinen 6 einen ähnlichen Versatz haben und eine kontinuierliche Anpassung ausreicht.

Fließen, z.B. durch Reparaturen, in Einzelfällen Leiterplatinen 6 anderer Chargen in den Fertigungsablauf, greift die automatische Korrektur in Verbindung mit dem Kontaktiertest ein und veranlaßt automatisch eine Neukontaktierung mit richtigem Versatz.

Zur Ausführung der verschiebbaren Aufnahmestifte 5 ergibt sich eine besonders einfache Lösung durch Realisierung der XY-Bewegung durch eine linear- und eine Drehbewegung.

Durch die bei der Gesamtanwendung eingesetzte Softwareunterstützung sowohl bei manueller als auch automatischer Verstellung erhält der Anwender automatische korrekt berechnete Werte und ist daher von den erforderlichen Rechenoperationen nicht betroffen.

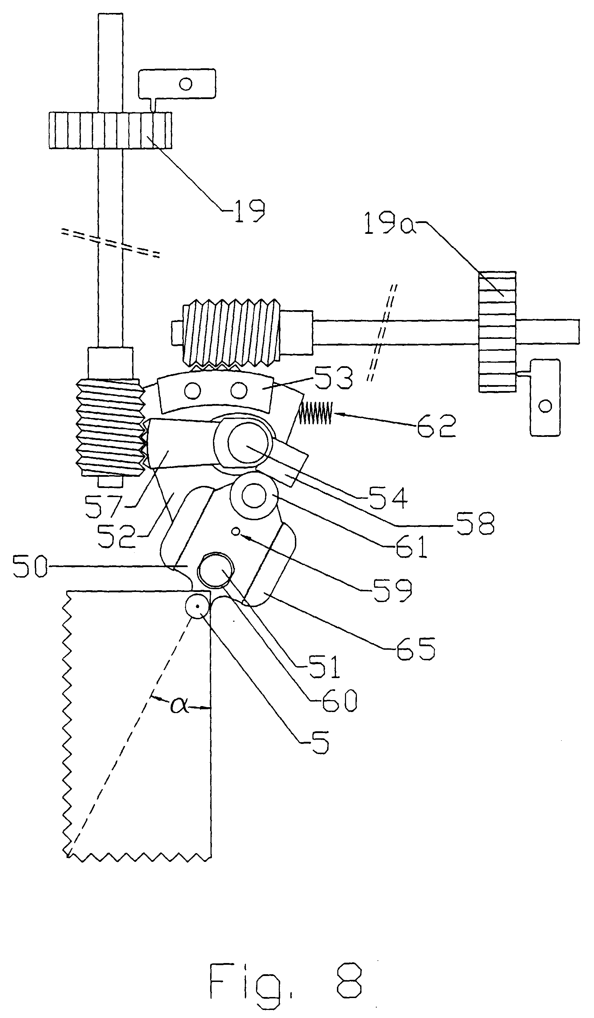

**Figur 8** zeigt den Aufbau der Aufnahmestifteinheit, mit der den Anforderungen entsprechend eine spielfrei einstellbare Position, sehr kleine Verfahrwege und bei jedem durch die Leiterplatine 6 festgelegten Winkel α eine bezogen auf die Leiterplatinenträgerplatte 4 senkrechte bzw. waagerechte Position der Antriebsachsen erreicht wird. Die Einheit besteht aus einem verschiebbaren Schlitten 50 mit dem Aufnahmestift 5, einer Umlenkrolle 61 und einem Langloch 63. Der Schlitten bewegt sich in einem Schlittenrahmen 65, der drehbar um die Drehachse 51 gelagert ist. Am Schlittenrahmen 65 ist mit verstellbarem Winkel eine Trägerplatte 52 montiert und an dieser das Zahnradsegment 53 befestigt. Die Schiebebewegung wird aus einer zweiten Drehbewegung um die Achse 54 abgeleitet, an der wiederum im Winkel verstellbar das Zahnradsegment 57 befestigt ist.

Über die Anpassung der im Winkel verstellbaren Zahnradsegmente erfolgt die Anpassung an den durch die Leiterplatine 6 vorgegebenen Winkel α.

Durch in jeder Achse vorgespannte Federn 59 und 62 wird für beide Achsen eine spielfreie Getriebefunktion realisiert. Die sich aus Zahnraduntersetzung und Hebelverhältnis ergebene Wegumsetzung wird zweckmäßig so dimensoniert, daß mit einer Gesamtumdrehung von z.B. 270 Grad der gesamte Wegbereich des Aufnahmestiftes 5 verfahren wird. Dadurch wird die bei manueller Verstellung wichtige Realisierung einer Skalenbeschriftung erheblich vereinfacht.

Für das gegenüberliegende Fangloch wird ein baugleiches Element mit einer bewegten und einer federnden Achse verwendet.

Das Schneckenradgetriebe bietet den Vorteil, daß die Antriebsmechanik beim Wechsel des individuellen Adapters abgetrennt werden kann, ohne daß sich die eingestellte Position verschiebt.

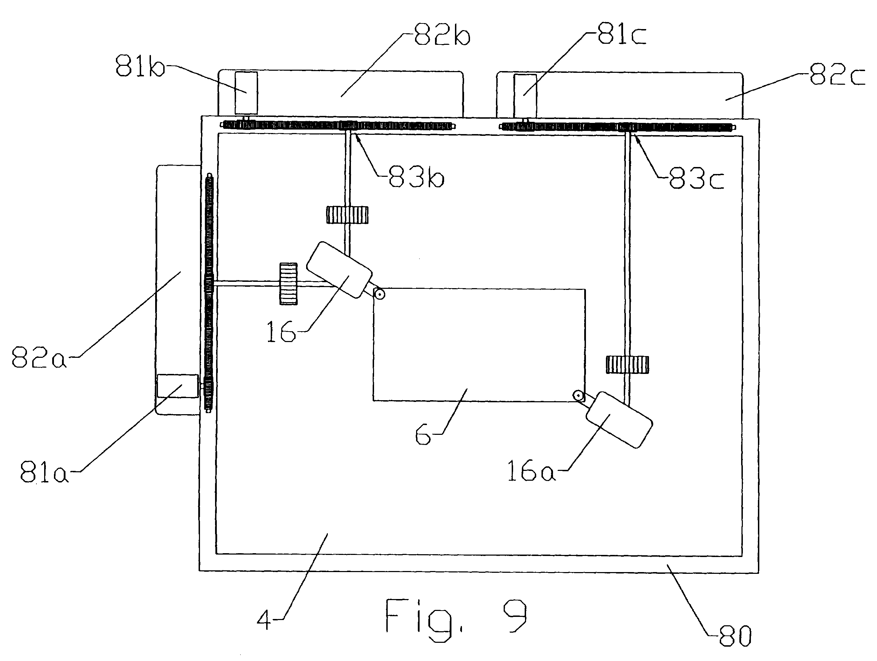

Eine besonders praktische Realisierung ergibt sich bei Adaptersystemen, bei denen bereits ein Grundgerät verwendet wird. Hier kann die Antriebsmechanik- und Steuerung im Grundgerät installiert werden und über geeignete Schnittstellen eine Entkopplung beim Adapterwechsel erfolgen. Ein Beispiel für die Anordnung ist in **Figur 9** dargestellt. Das Grundgerät, in das die leiterplatinenspezifischen Adapter eingesetzt werden, ist als Rahmen 80 mit drei anmontierten Antriebseinheiten 82a bis 82c dargestellt. Da die Position der adapterspezifischen Verstelleinheiten 16 je nach Größe der Leiterplatine 6 unterschiedlich ist, wird über die Motoreinheiten 81a-c zunächst eine Zahnstange bewegt. Auf diese Zahnstange setzen dann die mit den Verstelleinheiten verbundenen Zahnräder 83a-c auf und übertragen die im Grundgerät erzeugte Antriebsbewegung auf den individuellen Prüfadapter.

Über das Grundgerät erfolgt dann auch die Auswertung der optischen Sensoren 14 und die Regelung der Antriebsmotore.

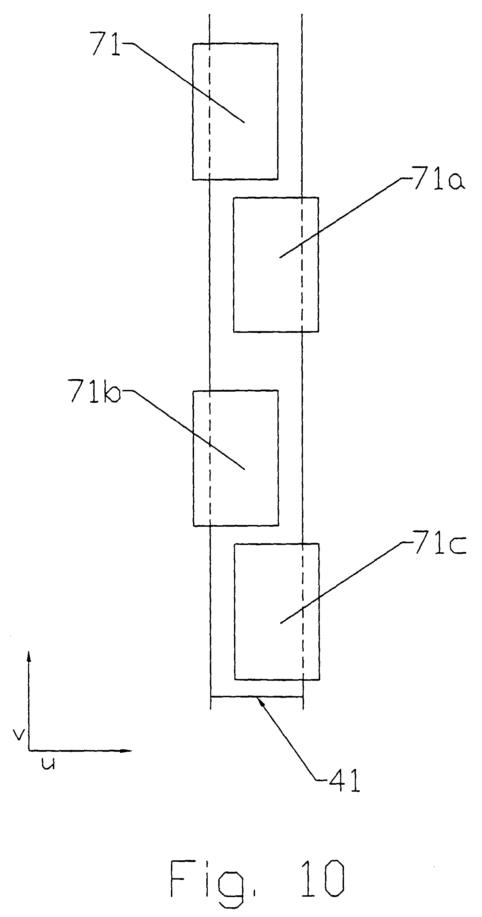

Die oben genannte optische Vermessung der Leiterbahnposition läßt sich in abgewandelter Form auch durch elektrische Meßverfahren durchführen. Bei diesen Meßverfahren ist gemeinsam, daß je Meßstelle zweckmäßig zwei mechanisch fest angeordnete elektrische Leiter eine vom mechanischen Abstand abhängige Änderung des elektrischen Meßwertes erfahren. Dies kann je nach Meßaufbau die Kapazität, die Induktivität oder induzierte Spannung sein. Bei zwei mechanisch leicht versetzten Meßaufnehmern kann die Differenz der Meßwerte ermittelt werden und so eine Kompensation von Störfaktoren erfolgen. Ein Beispiel für die Anordnung einer kapazitiven Messung ist in **Figur 10** dargestellt. Ein Leiterbahnsegment 41 der Leiterplatine und mindestens zwei im Adapter an geeigneter Position montierte elektrisch leitende Metallstreifen 71 und 71a stellen beim Kontaktieren der Leiterplatine 6 zwei zwar geringe, aber meßtechnisch mit vertretbarem Aufwand erfaßbare Kapazitäten dar. Wegen des geringen Meßwertes der Kapazität ist es sinnvoll, in den Sensor 14 einen Meßverstärker zu integrieren.

Bei richtiger Leiterbahnposition sind die Kapazitätswerte zwischen den Metallflächen 41 und 71 sowie zwischen 71a und 41 identisch. Bei einem Versatz in U-Richtung läßt sich aus der Differenz der Kapazitätswerte die Verschiebung berechnen. Werden mehrere Sensoren (hier zusätzlich 71b und 71c) angeordnet, lassen sich die Messung beeinflussende Fehlerquellen (z.B. lokale Ätzfehler an der Leiterbahn) erkennen und berücksichtigen. Analog zu dieser Kapazitätsmessung sind abgewandelte Meßverfahren bezüglich der Induktivität oder der z.B. durch kapazitive Kopplung übertragenden Spannung möglich.

In Verbindung mit der bisher beschriebenen Versatzkorrektur ist es zur Erzielung der gewünschten sehr geringen Gesamttoleranz zweckmäßig, die beschriebene Versatzkorrektur mit einer Korrektur der nadelbedingten Fehler zu kombinieren. Bekannt sind Verfahren, in denen durch eine verengte Führungsbohrung in der Leiterplatinenträgerplatte 4 oder durch eine zusätzliche, in der Leiterplatinenträgerplatte 4 montierte Nadel eine Führung unmittelbar an der Kontaktstelle durchgeführt wird. Eine weitere, denkbare Alternative von Nadeln mit sehr kurzen Federweg ist zumindest bei der Leiterplatinenunterseite meist nicht anwendbar, da neben kleinsten Testpunkten an anderer Stelle oft auch durchgesteckte Bauteilanschlüsse kontaktiert werden und hier aus Toleranzgründen ein größerer Federweg vorgesehen ist.

Das oben genannte und häufig angewendete Verfahren der verengten Führungsbohrung in der Leiterplatinenträgerplatte 4 erschwert wegen des durch rückseitige Bauteile erforderlichen Abstandes zwischen Leiterplatinenträgerplatte 4 und Leiterplatine 6 eine unmittelbarer Nachführung bis zur Leiterplatinenunterseite. Weiterhin kann bei Verwendung der kostengünstig in großer Stückzahl verwendeten Standardnadeln bauformbedingt nur ein sehr kurzes Stück der Dicke der Leiterplatinenträgerplatte 4 zur Nachführung genutzt werden. Ist diese Nachführung durch längeren Betrieb verschlissen, müßte die gesamte Leiterplatinenträgerplatte 4 mit u.U. hohem Montageaufwand erneuert werden.

Ein weiterer Nachteil der verengten Nachführung ist, daß eine für die optimale Nachführung geeignete Geometrie des Bohrloches auf den für den Adapterbau üblichen Leiterplattenbohrmaschinen nur mit hohem Aufwand hergestellt werden kann.

Eine technisch verbesserte Lösung wird im bereits erwähnten US Patent 5,510,722 beschrieben, wo eine eigene Nadeln in die Leiterplatinenträgerplatte 4 montiert und direkt dort geführt wird. Nachteilig sind jedoch der hohen Kostenaufwand und die zusätzliche elektrische Kontaktstelle.

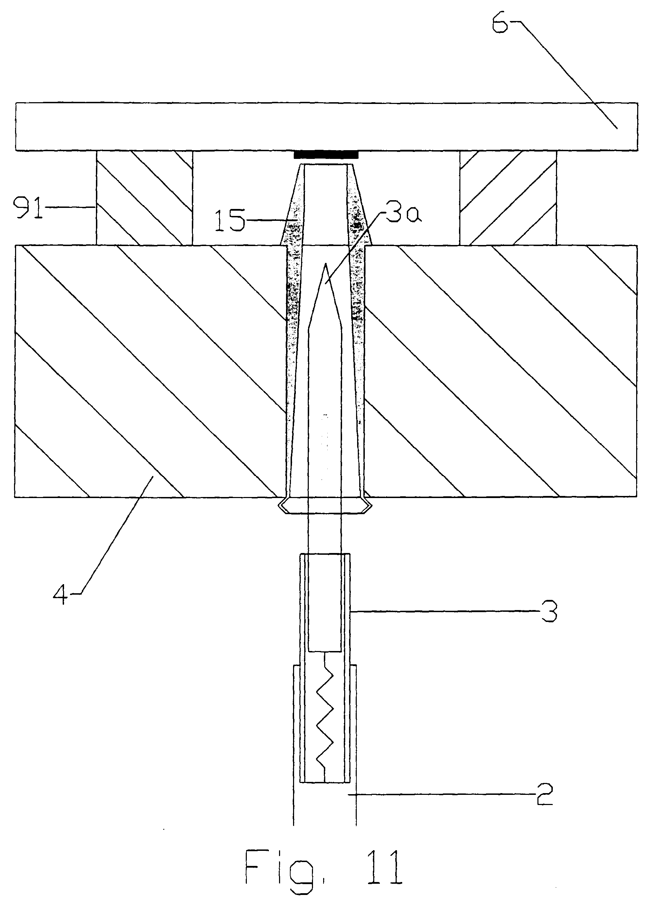

Zwei erfindungsgemäß verbesserte Lösung werden in Figur 11 und Figur 12 beschrieben. Bei der ersten Variante **(Figur 11)** wird in die Leiterplatinenträgerplatte 4 eine zusätzliche, zweckmäßigerweise als Drehteil hergestellte Führungshülse 15 eingesetzt, deren Geometrie optimal an die Nachführungsanforderungen angepaßt werden kann. Von Vorteil ist, daß für die Hülse ein Material mit guten Führungseigenschaften (z.B. Messing bei Stahlkolben) eingesetzt werden kann, der Abstandsbereich zwischen Leiterplatinenträgerplatte 4 und Leiterplatine 6 zur Führung mitbenutzt wird, die Teile bei Verschleiß leicht auswechselbar sind und die Bohrunggeometrie in der Hülse einfacher optimal an die Anforderungen angepaßt werden kann. Die dargestellte Hülse wird von oben in die Leiterplatinenträgerplatte 4 eingesetzt und läßt sich z.B. durch Einrasten fest montieren sowie über ein Ausdrückwerkzeug wieder demontieren.

Ein weiterer Vorteil ist die leichte Änderbarkeit des Führungsdurchmessers direkt während des Produktionsanlaufes. Sollte sich z.B. herausstellen, daß eine gewählte sehr enge Nachführung im Serienbetrieb an einzelnen Stellen zu sporadischem Verklemmen des Federkontaktstiftes führt, kann der Führungsdurchmesser durch Austausch der Nachführungshülse 15 leicht angepaßt werden.

Ein weitere Alternative zur verbesserten Nachführung über eine spezielle Nachführungsplatte 95 wird in **Figur 12** dargestellt. Die linke Darstellung zeigt den Adapter bei nicht angesaugter Leiterplatine 6, die rechte im angesaugten Zustand. Die Nachführungsplatte 95 wird auf die Leiterplatinenträgerplatte 4 zweckmäßigerweise über Paßstifte und mehrere Schrauben aufmontiert und entspricht etwa der Größe der zu kontaktierenden Leiterplatine 6. Durch die in Verbindung mit der nachgeführten Leiterplatinenträgerplatte 4 zweistufige Nachführung wird ein zuverlässigeres Eintauchen des Federkontaktstiftes 3 bei sehr enger Nachführung gewährleistet. Vor allem kann die Nachführungsplatine 95 bei Verschleiß leichter ausgetauscht werden und es ergibt sich ein geringerer Abstand der engsten Nachführung in vertikaler Richtung näher zu der zu prüfenden Leiterplatine 6. Eventuelle Konflikte mit von unten montierten Bauteilen können einfach aus entsprechende Aussparung in der Nachführungsplatine 95 gelöst werden. Ein weiterer Vorteil ist, daß für die Nachführungsplatte 95 ein anderes, an die Nachführungsanforderungen besser angepaßtes Material verwendet werden kann als bei der Leiterplatinenträgerplatte 4. Weiterhin wird durch die geringe Dicke der separaten Nachführungsplatte 95 das präzise und verlauffreie Bohrungen bei kleinsten Bohrdurchmessern wesentlich erleichtert.

Eine weitere Besonderheit bei der Versatzkorrektur ergibt sich, falls eine doppelseitige Kontaktierung erforderlich ist. Hierbei tritt das zusätzliche Problem auf, daß das untere und die obere Kupferbild gegenüber dem Bohrbild einen unterschiedlichen Versatz haben können.

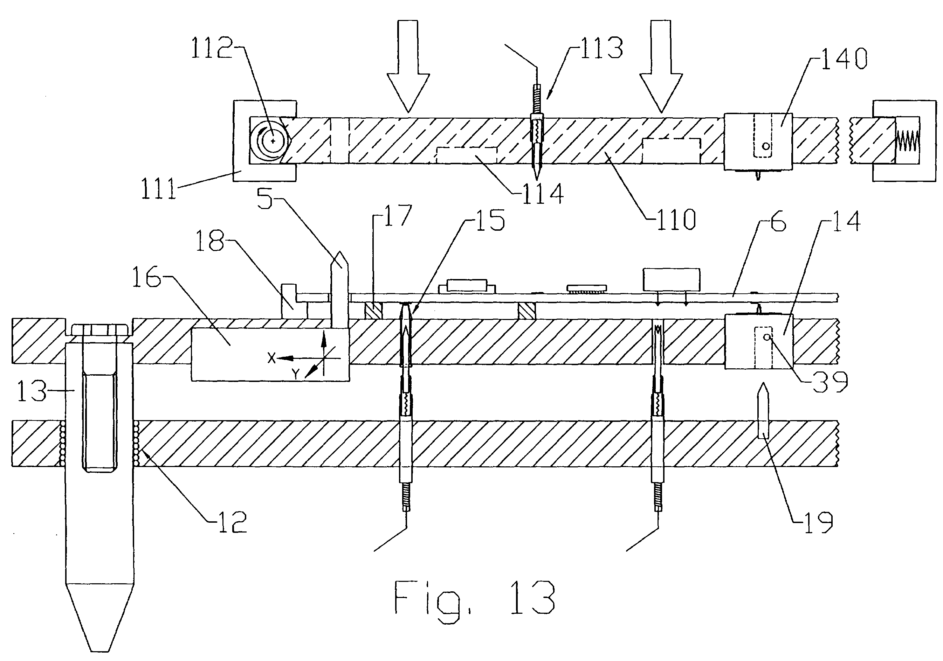

Bei mittleren Genauigkeitsanforderungen genügt es, durch zusätzliche Sensoren auf der Oberseite auch den Versatz auf der Oberseite zu messen und bei der Korrekturberechnung zu berücksichtigen.
Bei hohen Genauigkeitsanforderungen ist eine separate Verstelleinheit auf der Oberseite erforderlich, die in **Figur 13** dargestellt ist. Diese muß die gesamte obere Nadelträgerplatte 110 verschieben, was zum Beispiel durch in der Figur für eine Achse dargestellte exzentrische Drehachse 112 erfolgen kann. Wie bereits vorher erwähnt, sollten hier bevorzugt Federkontaktstifte 113 mit geringem Federweg und damit geringerem axialen Taumelspiel eingesetzt werden.

In Figur 13 sind die technisch bekannten Verfahren, um die obere Nadelträgerplatte 110 drehbar und linear absenkbar mit dem unteren Adapter zu verbinden sowie eine Vorrichtung zur Bewegung des oberen Sensors 140 nicht separat eingezeichnet.

Alternativ bietet es sich insbesondere bei Adaptersystemen mit Grundgerät an, einen universell verwendbaren Aufsatz für die Oberseiteneinheit zu verwenden, bei der über zwei manuell oder automatisch verschiebbare Aufnahmestifte die obere Platte insgesamt verschoben wird.

Die Verknüpfung mit einer Nadelnachführung hat bei der Oberseitenkontaktierung keine so große Bedeutung, da bei der größten Zahl der Anwendungen von der Oberseite nur plane Flächen kontaktiert werden. Hierzu können dann Nadeln mit einem erheblich geringen Federweg und damit auch deutlich geringerem Taumelspiel eingesetzt werden.

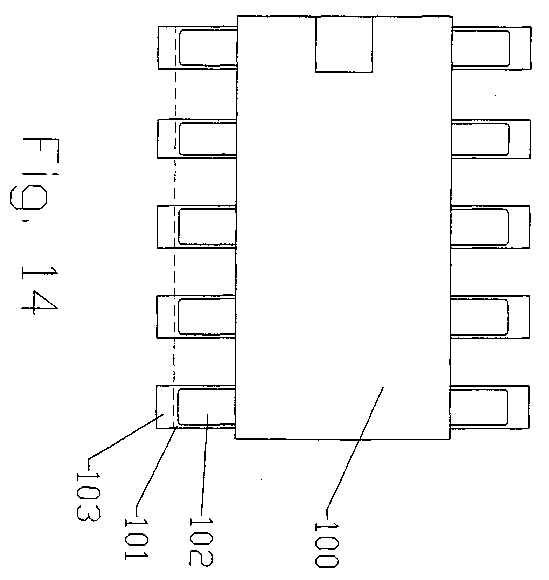

Die durch die Erfindung insgesamt erreichbare hohe Positionsgenauigkeit der Kontaktierung bringt dem Anwender nicht nur den Vorteile verkleinerter Prüfpads, sondern erlaubt es auch, für bisher wegen fehlender Prüfpads mit Nadelbettadapter nicht testbaren Baugruppen das sehr wirtschaftliche Testverfahren mit Prüfadapter einzusetzen. **Figur 14** zeigt als Beispiel Anschlußpads 101 eines oberflächenmontierten Bauteils 100 mit den aufgelöteten Anschlußbeinchen 102. Bei vielen Bauteilgehäuseformen ergibt sich ein Padbereich 103, der für eine Kontaktierung bei ausreichender Kontaktiergenauigkeit geeignet wäre.

Weiterhin könnten bei fehlenden Testpads nur durch eine Veränderung der Lötstoppmaske Leiterbahnbereiche als Testpads freigestellt werden. Bei dünnen Leiterbahnen kann weiterhin durch eine partielle Vergoldung eine gute Kontaktierung auch bei Verzicht auf sehr spitze und damit aggressive Nadelformen erreicht werden. Bei Platinen mit z.B. großer Ausdehnung in einer Richtung können z.B. längliche Bereiche in dieser Richtung ausgewählt werden, so daß ein Verzug besser toleriert wird.

Dabei ist es zweckmäßig, bei nicht vom Entwickler vorgegebenen, nachzusetzenden Testpads unter Kenntnis der genauen Größe der Bauelementgeometrien, der verwendeten Kupferpads auf der Leiterplatine und des Leiterbahnverlaufes eine durch Software optimierte Auswahl der für die Prüfadaptierung besten Kontaktpunkte durchzuführen. Hierbei müssen die Parameter Prüfpfadabstand (und damit Nadelgröße), Kontaktbereichgröße in x- und y-Richtung, maximale Dehnung oder Schrumpfung der Platine in X und Y Richtung bezogen auf die Platinenmitte und Genauigkeit der Nadelnachführung aufeinander abgestimmt werden. Die dabei festgelegten Nadelpositionen fließen dann in die Datengenerierung für den Prüfadapterbau ein.

Nicht in allen Fällen wird der volle Umfang der automatischen Korrektur zur sicheren Kontaktierung benötigt. Dies ist insbesondere der Fall, wenn erfahrungsgemäß die verwendeten Platinen eine hohe Genauigkeit haben oder wenn von der Entwicklung noch relativ große Testpunkte bereitgestellt werden können.

In diesen Fällen ist es eine Alternative, zunächst nur manuell einstellbare Fangstifte vorzusehen und anhand des Nadelabdruckes mit einem Mikroskop den Nadelversatz zu messen. Durch einen modularen Aufbau ließe sich dann die automatische Korrektur nachrüsten.

Die erfindungsgemäß verbesserte Ausführung der Stelleinheit mit reproduzierbar verstellbaren und mit Skalen versehenen Einstellrädern erlaubt auch hier einen anwendungsgeeigneten Ablauf, da nach Ermittlung des Versatzes und Umrechnung der Werte auf die Stelleinheit eine gezielte, in einem Korrekturdurchlauf durchführbare Korrektur erfolgen kann. Auch hier ist es zweckmäßig, eine durch Software unterstützte Einstellhilfe vorzusehen. Da die Korrektur ohne Demontage des Adapters und mit eindeutigen Nachstellanweisungen erfolgen kann, ist die geforderte einfache Korrekturmöglichkeit während des Produktionsprozesses erfüllt.

## Patentansprüche

1. Testadapter zum Testen einer insbesondere bestückten Leiterplatine (6), umfassend:
- eine Nadelträgerplatte (1), an der Testnadeln (3) zum Kontakt der Kolben (3a) der Testnadeln (3a) mit Testpunkten (7) der Leiterplatine (6) befestigt sind,
- eine Leiterplatinenträgerplatte (4), an der die Leiterplatine (6) mittels Aufnahmestiften (5) koppelbar ist, die zwischen der Leiterplatine (6) und der Nadelträgerplatte (1) angeordnet ist und die Durchgangsbohrungen (8) für die Testnadeln (3) aufweist, und
- eine Einstelleinrichtung (50-65), mittels derer die Position der Leiterplatine (6) in Bezug auf die Kolbenpositionen der Testnadeln (3) so einstellbar ist, daß bei einer Bewegung der Nadelträgerplatte (1) auf die Leiterplatine (6) zu die Kolben (3a) der Testnadeln (3) exakt auf die Testpunkte auf der Leiterplatine (6) treffen,
dadurch gekennzeichnet,
- daß an jedem Aufnahmestift (5) eine Einstelleinrichtung (50-65) angreift, die die Aufnahmestifte (5) in der Leiterplatinenträgerplatte (4) in Richtung einer zu der Leiterplatinenebene parallelen Ebene verstellbar verankert.

2. Testadapter gemäß Anspruch 1, dadurch gekennzeichnet,
daß der Testadapter eine Sensorvorrichtung (14) mit zumindest zwei Sensoren umfaßt, die auf der Leiterplatinenträgerplatte (4) vorgesehen sind und mit denen Bezugspunkte einer Schaltungsanordnung auf der an der Leiterplatinenträgerplatte (4) gekoppelten Leiterplatine (6) meßbar sind.

3. Testadapter gemäß Anspruch 1 oder 2, dadurch gekennzeichnet,
daß mit der Sensorvorrichtung (14) ohne die Notwendigkeit spezieller Bezugsmarken der Versatz zwischen der Leiterplatinenträgerplatte (4) und der an dieser gekoppelten Leiterplatine (6) meßbar ist.

4. Testadapter gemäß Anspruch 2 oder 3, dadurch gekennzeichnet,
daß die Sensorvorrichtung (14) bewegbare Punktsensoren umfaßt.

5. Testadapter gemäß einem der Ansprüche 2 bis 4, dadurch gekennzeichnet,
daß die Sensorvorrichtung (14) bewegbare optische Reflexsensoren umfaßt.

6. Testadapter gemäß einem der Ansprüche 2 bis 5, dadurch gekennzeichnet, daß die Bewegung der Sensorvorrichtung (14) über die Bewegung der Nadelträgerplatte (1) auf die Leiterplatine (6) zu erfolgt.

7. Testadapter gemäß Anspruch 2 oder 3, dadurch gekennzeichnet, daß die Sensorvorrichtung (14) elektrisch leitende Flächen umfaßt, die zusammen mit Leiterbahnen der Leiterplatine ein versatzproportionales elektrisch meßbares Element wie eine Kapazität oder eine Induktivität darstellen.

8. Testadapter gemäß einem der Ansprüche 2 bis 7, dadurch gekennzeichnet,
daß die Sensoren der Sensorvorrichtung (14) in der Nähe der Mitte der Leiterplatine (6) angeordnet sind.

9. Testadapter gemäß einem der Ansprüche 2 bis 8, dadurch gekennzeichnet,
daß die Bezugspunkte bestimmte Leiterbahnen oder Leiterbahnkanten der Schaltungsanordnung der Leiterplatine (6) sind.

10. Testadapter gemäß einem der Ansprüche 2 bis 9, dadurch gekennzeichnet,
daß zur Messung eines xy-Versatzes ein Sensor die Position einer ersten Leiterbahn oder Leiterbahnkante mißt und ein anderer Sensor die Position einer zweiten zu der ersten Leiterbahn senkrecht verlaufenden, räumlich getrennten Leiterbahn oder Leiterbahnkante mißt.

11. Testadapter gemäß einem der vorstehenden Ansprüche, dadurch gekennzeichnet, daß die Mittel zwei Aufnahmestifte (5) umfassen, deren eines Ende jeweils in Aufnahmelöcher (20) der Leiterplatine (6) eingreifen kann und deren anderes Ende jeweils über einen Einsteilmechanismus (16) verstellbar in der Leiterplatinenträgerplatte (4) verankert ist.

12. Testadapter gemäß Anspruch 11, dadurch gekennzeichnet,
daß der eine Aufnahmestift in zwei senkrechten Richtungen parallel zu der Leiterplatinenebene mittels eines Einstellmechanismusses (16) bewegbar ist und daß der andere Aufnahmestift in eine Richtung mittels des Einstellmechanismusses (16) bewegbar ist und in der Richtung senkrecht dazu über ein federndes Element geführt bewegbar ist.

13. Testadapter gemäß Anspruch 11 oder 12, dadurch gekennzeichnet,
daß die Aufnahmestifte (5) zum Ausgleich des Spiels der Aufnahmestifte (5) in den Aufnahmelöchern (20) der Leiterplatine (6) an der Leiterplatine (6) einseitig gefedert befestigt sind.

14. Testadapter gemäß einem der vorstehenden Ansprüche, dadurch gekennzeichnet,
daß die Bewegung der Einstelleinrichtung (5, 50-65) über einen Motor erfolgt und
daß eine Steuerung für den Motor vorgesehen ist, die den Motor abhängig von Signalen der Sensoren (14) ansteuert, so daß die Einstelleinrichtung (5, 50-65) in einem automatischen Regelkreis verstellt wird.

15. Testadapter gemäß einem der vorstehenden Ansprüche, dadurch gekennzeichnet,
daß die Bewegung der Einstelleinrichtung (5, 50-65) über manuell mit Skalen versehene Stellräder erfolgt.

16. Testadapter gemäß einem der vorstehenden Ansprüche, dadurch gekennzeichnet,
daß in den Durchgangsbohrungen (8) der Leiterplatinenträgerplatte (4) Führungshülsen (15) für die Testnadeln (3) vorgesehen sind.

17. Testadapter gemäß einem der Ansprüche 1 bis 15, dadurch gekennzeichnet,
daß auf der der Leiterplatine (6) zugewandten Seite der Leiterplatinenträgerplatte (4) eine Führungsplatte (95) angeordnet ist, die bei den Durchgangsbohrungen (8) der Leiterplatinenträgerplatte (4) Führungsbohrungen für die Testnadeln (3) aufweist.

18. Testadapter gemäß einem der Ansprüche 2 bis 17, dadurch gekennzeichnet,
daß eine Auswerteeinrichtung mit der Sensorvorrichtung (14) und der Einstelleinrichtung (5, 50-65) verbunden ist und
daß die Auswerteeinrichtung die von der Sensorvorrichtung (14) erfaßten Positionen bestimmter Leiterbahnen oder Leiterbahnkanten der Schaltungsanordnung der Leiterplatine (6) mit den entsprechenden theoretischen Positionen vergleicht und so den Versatz des tatsächlichen Leiterbahnbildes ermittelt und an die Einstelleinrichtung (5, 50-65) überträgt.

19. Testadapter gemäß einem der vorstehenden Ansprüche, dadurch gekennzeichnet,
daß der Testadapter drei Sensoren zum Erfassen des Versatzes und der Verdrehung des Leiterbahnbildes zu den Bohrlöchern umfaßt.

20. Testadaptersystem, bei dem zwei Testadapter gemäß einem der vorstehenden Ansprüche auf beiden Seiten der zu testenden Leiterplatine (6) angeordnet sind, wobei die jeweiligen Einstelleinrichtungen eine unabhängige Einstellung der beiden Testadapter in Bezug auf die jeweiligen Schaltungsanordnungen auf dem jeweiligen Seiten der Leiterplatine (6) ermöglichen.
